# EUROPEAN PATENT APPLICATION

(11) **EP 4 790 899 A1**
(43) Date of publication of application: **12.08.2026**
(21) Application number: 25880284.2
(22) Date of filing: 01.10.2025
(51) Int. Cl.: H03K 5/133, H03K 5/15, G06F 1/10

(54) **RADIATION-RESISTANT CIRCUIT HAVING FEEDBACK STRUCTURE, AND SEMICONDUCTOR DEVICE COMPRISING SAME**

(30) Priority: 15.10.2024 KR 20240140164
(71) Applicant: IUCF-HYU (Industry-University Cooperation Foundation Hanyang University), Seoul 04763 (KR)
(72) Inventor: SONG, Ickhyun, Seoul 04763 (KR); JEONG, Junhwa, Seoul 04763 (KR); KIM, Taeyeong, Seoul 04763 (KR)
(74) Representative: Prüfer & Partner mbB Patentanwälte · Rechtsanwälte
(86) International application number: PCT/KR2025/015730
(87) International publication number: WO 2026/084354

(57) **Abstract**

A radiation-hardened circuit is disclosed. The radiation-hardened circuit includes: a time delay circuit configured to invert an input signal received through a first terminal and to output an inverted input signal through a second terminal; a first output circuit configured to output a first clock signal by mitigating a transient voltage increase of a clock signal; a second output circuit configured to output a second clock signal by mitigating a transient voltage decrease of the clock signal; and a switch circuit configured to transmit one of the first clock signal and the second clock signal to the first terminal in response to the inverted input signal.

## Description

### TECHNICAL FIELD

The present disclosure relates to an electronic circuit, and more particularly, to a radiation-hardened circuit having a feedback structure capable of generating a stable clock signal by mitigating a transient voltage variation induced in the clock signal by radiation or noise, and to a semiconductor device including the same.

### BACKGROUND ART

A clock signal functions to provide timing signals in a digital circuit. The clock signal is periodic and repetitive, generally having a square waveform with a constant period. The clock signal is utilized for synchronization, timing, and pulse generation.

In a synchronization process, the clock signal enables a plurality of digital circuits to perform operations simultaneously. For example, various operations of a processor, such as a Central Processing Unit (CPU), are executed in synchronization with the clock signal.

In a timing process, the clock signal determines the timing for reading and writing data, whereby the transmission and processing of data are governed by the clock signal. In a pulse generation process, the clock signal generates periodic pulses to control the operations of various digital circuits.

The clock signal plays a critical role in various electronic devices, including a CPU, a memory, or a timer, and serves as a key determinant of the overall operating speed and efficiency of a digital system.

Malfunctions in the clock signal may lead to various operational errors. For instance, if the clock signal is unstable or its period is irregular, data transmission may fail, thereby causing data loss or corruption.

Furthermore, misalignment of the clock signal may disrupt the timing of digital circuits, shifting the read and write timings of data and resulting in the processing of erroneous data.

Additionally, an excessively long clock period may reduce processing speed, leading to a decrease in the throughput of a digital system, which consequently degrades performance and reduces overall processing capacity.

Moreover, if the arrival times of the clock signal at various parts of a digital circuit differ from one another, clock skew occurs. Such clock skew may prevent certain portions of the digital circuit from properly receiving signals and may cause data synchronization failures.

### DESCRIPTION OF EMBODIMENTS TECHNICAL PROBLEM

A technical problem to be solved by the present disclosure is to provide a radiation-hardened circuit having a feedback structure capable of stabilizing a clock signal by mitigating or eliminating transient voltage variations induced in the clock signal by radiation or noise, and a semiconductor device including the same.

### SOLUTION TO PROBLEM

According to embodiments of the present invention, a radiation-hardened circuit includes a time delay circuit configured to invert an input signal received through a first terminal and to output an inverted input signal through a second terminal; a first output circuit configured to output a first clock signal by mitigating a transient voltage increase of a clock signal; a second output circuit configured to output a second clock signal by mitigating a transient voltage decrease of the clock signal; and a switch circuit configured to selectively transmit one of the first clock signal and the second clock signal to the first terminal in response to the inverted input signal.

According to embodiments of the present invention, a semiconductor device includes: a clock signal generator configured to output a clock signal; and a radiation-hardened circuit coupled to the clock signal generator, wherein the radiation-hardened circuit includes: a time delay circuit configured to invert an input signal received through a first terminal and to output an inverted input signal through a second terminal; a first output circuit configured to output a first clock signal by mitigating a transient voltage increase of the clock signal; a second output circuit configured to output a second clock signal by mitigating a transient voltage decrease of the clock signal; and a switch circuit configured to transmit one of the first clock signal and the second clock signal to the first terminal in response to the inverted input signal.

The semiconductor device may further include a digital circuit comprising an input terminal coupled to the first terminal, wherein the digital circuit is configured to use, as an operating clock signal, the one of the first clock signal and the second clock signal received through the input terminal.

The first output circuit is configured to output the first clock signal maintaining a low level by mitigating the transient voltage increase occurring at the low level of the clock signal, and the second output circuit is configured to output the second clock signal maintaining a high level by mitigating the transient voltage decrease occurring at the high level of the clock signal.

### ADVANTAGEOUS EFFECTS OF DISCLOSURE

According to an embodiment of the present disclosure, the radiation-hardened circuit is effective in generating a stable clock signal by mitigating or eliminating transient voltage variations induced in a clock signal by radiation or noise.

Furthermore, according to an embodiment of the present disclosure, the radiation-hardened circuit provides robust protection against radiation or noise that may affect an output clock signal, thereby enhancing the operational stability and reliability of a digital system incorporating the radiation-hardened circuit.

### BRIEF DESCRIPTION OF DRAWINGS

FIG. 1 is a conceptual block diagram illustrating a radiation-hardened circuit according to an embodiment of the present disclosure.
FIG. 2 is a timing diagram of signals related to an operation of the radiation-hardened circuit illustrated in FIG. 1.
FIG. 3 is a conceptual diagram illustrating an embodiment of a clock tree including the radiation-hardened circuit illustrated in FIG. 1.
FIG. 4 is a conceptual diagram illustrating another embodiment of a clock tree including the radiation-hardened circuit illustrated in FIG. 1.
FIG. 5 is a conceptual diagram illustrating still another embodiment of a clock tree including the radiation-hardened circuit illustrated in FIG. 1.
FIG. 6 is a conceptual diagram illustrating yet another embodiment of a clock tree including the radiation-hardened circuit illustrated in FIG. 1.
FIG. 7 is a conceptual diagram illustrating a clock mesh including the radiation-hardened circuit illustrated in FIG. 1.

### BEST MODE

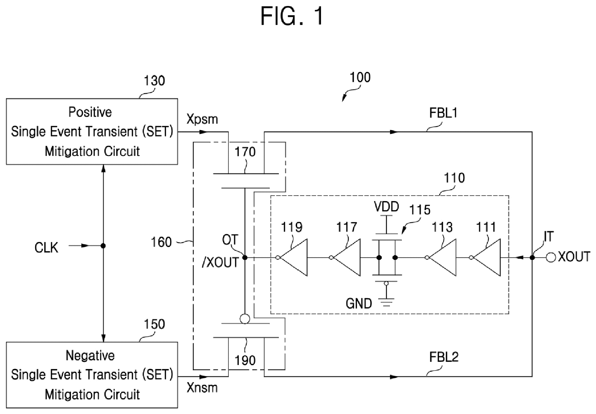

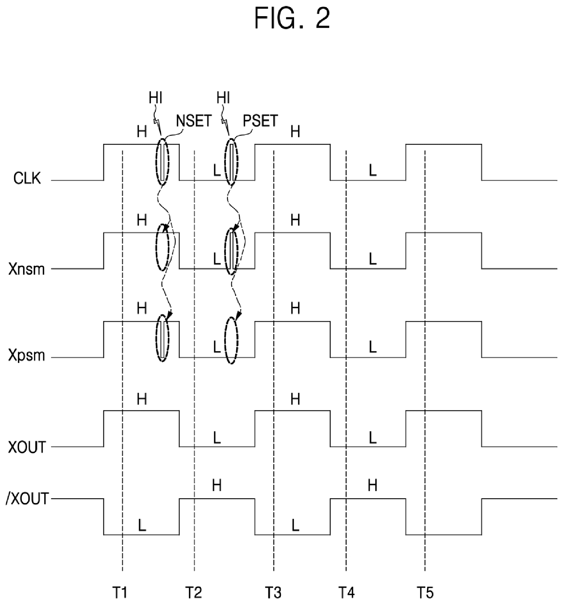

FIG. 1 is a conceptual block diagram illustrating a radiation-hardened circuit according to an embodiment of the present disclosure, and FIG. 2 is a timing diagram of signals related to an operation of the radiation-hardened circuit illustrated in FIG. 1.

Referring to FIGS. 1 and 2, a semiconductor device 100 includes a time delay circuit 110, a first output circuit 130, a second output circuit 150, and a switch circuit 160.

The semiconductor device 100 may also be referred to as an integrated circuit (IC), a semiconductor chip, a radiation-hardened circuit, or a single-output single-event transient (SET) mitigation (SSM) circuit..

The radiation-hardened circuit 100 refers to an electronic circuit configured to minimize the adverse effects of radiation. The radiation-hardened circuit 100 may be applied to electronic devices requiring high reliability, such as spacecraft, satellites, nuclear power plants, or other high-radiation environments.

The time delay circuit 110 inverts an input signal XOUT received through a first terminal (or also referred to as a "first node") IT, and outputs an inverted input signal /XOUT through a second terminal (or also referred to as a "second node") OT.

The first terminal IT may serve as an input terminal of the radiation-hardened circuit 100 and simultaneously as an input terminal of another digital circuit connected or coupled thereto. Accordingly, from the perspective of the radiation-hardened circuit 100, 'XOUT' is an input signal of the radiation-hardened circuit 100 while also being an output signal transmitted to the other digital circuit; whereas from the perspective of the other digital circuit, 'XOUT' is an input signal.

The time delay circuit 110 delays a signal XOUT (e.g., a clock signal Xpsm or Xnsm) received through the first terminal IT by half a period of the clock signal Xpsm or Xnsm, and outputs an inverted clock signal /XOUT through the second terminal OT.

The time delay circuit 110 includes a plurality of inverters 111, 113, 117, and 119 connected in series, and a transmission gate 115.

The inverters 111 and 113 serve as an input buffer for the transmission gate 115, and the inverters 117 and 119 serve as an output buffer for the transmission gate 115.

The input buffer, including the inverters 111 and 113, and the output buffer, including the inverters 117 and 119, serve to isolate the first terminal IT from the second terminal OT. Furthermore, the input buffer is configured to mitigate interaction between the signal XOUT and the transmission gate 115, while the output buffer is configured to mitigate interaction between the transmission gate 115 and the output signal /XOUT.

In the transmission gate 115, a power supply voltage VDD is supplied to a gate of an NMOS transistor and a ground voltage GND is supplied to a gate of a PMOS transistor. Accordingly, the transmission gate 115, which serves as a switching element, is maintained in a permanently-on state (or always-on state).

A signal XOUT passing through the transmission gate 115 is delayed according to a resistive component and a parasitic capacitive component of the transmission gate 115. The delay time increases as the magnitudes of the resistive component and the parasitic capacitive component increase.

In a design stage of the time delay circuit 110, by adjusting the resistive and parasitic capacitive components of the transmission gate 115, the time delay circuit 110 may be configured to delay the signal XOUT by half a period of the signal XOUT, thereby outputting an inverted signal /XOUT through the second terminal OT.

The first output circuit 130 may mitigate or eliminate a transient voltage increase in the clock signal CLK and output a stabilized first clock signal Xpsm to a first line FBL1.

The second output circuit 150 may mitigate or eliminate a transient voltage decrease in the clock signal CLK and output a stabilized second clock signal Xnsm to a second line FBL2.

The first output circuit 130 may be implemented as a mitigation circuit configured to mitigate a positive single-event transient (SET).

Herein, a single-event transient (SET) refers to a phenomenon in which a transient pulse occurs, thereby causing a change in the logic level of a signal.

The positive SET mitigation circuit 130 is configured to protect the semiconductor device 100 from a transient voltage increase (PSET) induced in the clock signal CLK by an external factor HI, such as radiation particles or noise. When such a PSET occurs, the functionality of the semiconductor device 100 or a digital system incorporating the same may be temporarily compromised, or operational errors may occur.

As illustrated in FIG. 2, when a logic low level L of the clock signal CLK is temporarily shifted or transition to a logic high level H due to radiation or a soft error HI, the positive SET mitigation circuit 130 may generate a first clock signal Xpsm that maintains the logic low level L by mitigating or eliminating the transient voltage increase PSET. In contrast, the negative SET mitigation circuit 150 is not configured to mitigate or eliminate the transient voltage increase PSET.

The transient voltage increase (PSET) may be restored to the logic low level (Xpsm=L) by the positive SET mitigation circuit 130, whereas it might not be restored to the logic low level L by the negative SET mitigation circuit 150.

The second output circuit 150 may be implemented as a mitigation circuit configured to mitigate a negative single-event transient (NSET).

The negative SET mitigation circuit 150 refers to a circuit configured to protect the semiconductor device 100 from a transient voltage decrease (NSET) induced in the clock signal CLK by an external factor HI, such as radiation particles or noise. When such an NSET occurs, the functionality of the semiconductor device 100 or a digital system incorporating the same may be temporarily compromised, or operational errors may occur.

As illustrated in FIG. 2, when a logic high level H of the clock signal CLK is temporarily shifted or transition to a logic low level L due to radiation or a soft error HI, the negative SET mitigation circuit 150 may generate a second clock signal Xnsm that maintains the logic high level H by mitigating or eliminating the transient voltage decrease NSET. In contrast, the positive SET mitigation circuit 130 is not configured to mitigate or eliminate the transient voltage decrease NSET.

The transient voltage decrease (NSET) may be restored to the logic high level (Xnsm=H) by the negative SET mitigation circuit 150, but it might not be restored to the logic high level H by the positive SET mitigation circuit 130.

At least one of the transient voltage increase (PSET) or the transient voltage decrease (NSET) may be induced by at least one of radiation or noise.

In response to the inverted input signal /XOUT, the switch circuit 160 is configured to transmit (or feedback) the first clock signal Xpsm to the first terminal IT through the first line FBL1, or transmit the second clock signal Xnsm to the first terminal IT through the second line FBL2.

The switch circuit 160 includes a first switch 170 configured to control the transmission of the first clock signal Xpsm to the first terminal IT, and a second switch 190 configured to control the transmission of the second clock signal Xnsm to the first terminal IT, in response to the inverted input signal /XOUT.

The first switch 170 and the second switch 190 operate complementarily. This complementary operation means that when one of the switches (either 170 or 190) is turned on, the other switch (the other of 170 and 190) is turned off, or that the two switches 170 and 190 operate alternately.

For example, one of the first switch 170 and the second switch 190 comprises a PMOS transistor, while the other comprises an NMOS transistor.

As illustrated in FIG. 2, the first clock signal Xpsm, the second clock signal Xnsm, and the input signal XOUT are in phase with each other.

At a first time point T1, when the signal XOUT having a logic high level H is input to the first terminal IT, the time delay circuit 110 outputs the inverted signal /XOUT having a logic low level L through the second terminal OT.

In response to the inverted signal /XOUT having the logic low level L, the NMOS transistor 170 is turned off and the PMOS transistor 190 is turned on. Accordingly, the second clock signal Xnsm of the second output circuit 150 is output (or fed back) to the first terminal IT via the second line FBL2.

At a second time point T2, when the signal XOUT (equivalent to Xnsm) having a logic low level L is input to the first terminal IT, the time delay circuit 110 outputs the inverted signal /XOUT having a logic high level H through the second terminal OT.

In response to the inverted signal /XOUT having the logic high level H, the NMOS transistor 170 is turned on and the PMOS transistor 190 is turned off. Accordingly, the first clock signal Xpsm of the first output circuit 130 is output (or fed back) to the first terminal IT via the first line FBL1.

At a third time point T3, when the signal XOUT (equivalent to Xpsm) having a logic high level H is input to the first terminal IT, the time delay circuit 110 outputs the inverted signal /XOUT having a logic low level L through the second terminal OT.

In response to the inverted signal /XOUT having the logic low level L, the NMOS transistor 170 is turned off and the PMOS transistor 190 is turned on. Accordingly, the second clock signal Xnsm of the second output circuit 150 is transmitted to the first terminal IT via the second line FBL2.

At a fourth time point T4, when the signal XOUT (equivalent to Xnsm) having a logic low level L is input to the first terminal IT, the time delay circuit 110 outputs the inverted signal /XOUT having a logic high level H through the second terminal OT.

In response to the inverted signal /XOUT having the logic high level H, the NMOS transistor 170 is turned on and the PMOS transistor 190 is turned off. Accordingly, the first clock signal Xpsm of the first output circuit 130 is transmitted to the first terminal IT via the first line FBL1.

At a fifth time point T5, when the signal XOUT (equivalent to Xpsm) having a logic high level H is input to the first terminal IT, the time delay circuit 110 outputs the inverted signal /XOUT having a logic low level L through the second terminal OT.

In response to the inverted signal /XOUT having the logic low level L, the NMOS transistor 170 is turned off and the PMOS transistor 190 is turned on. Accordingly, the second clock signal Xnsm of the second output circuit 150 is transmitted to the first terminal IT via the second line FBL2.

As described above, the switch circuit 160 alternately transmits the first clock signal Xpsm and the second clock signal Xnsm to the first terminal IT based on the logic level of the signal /XOUT at the second terminal OT.

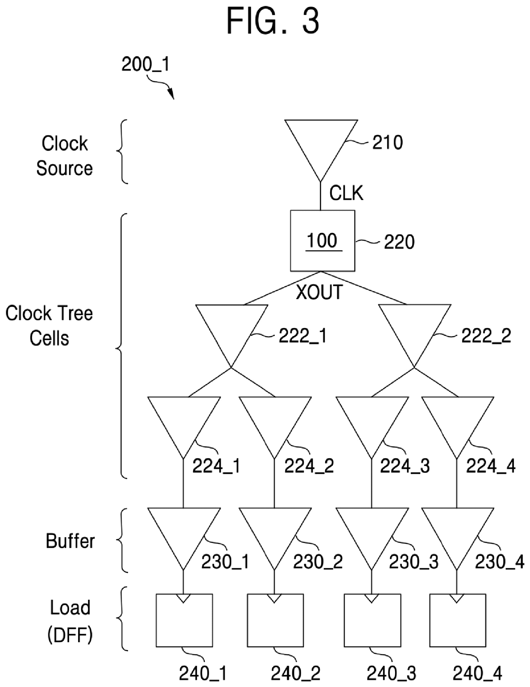

FIG. 3 is a conceptual diagram illustrating an embodiment of a clock tree incorporating the radiation-hardened circuit illustrated in FIG. 1.

Referring to FIG. 3, a clock tree 200_1 (which may be referred to as a semiconductor device) corresponding to a clock distribution network includes a clock source 210, a plurality of clock tree cells 220, 222_1, 222_2, and 224_1 to 224_4, a plurality of buffers 230_1 to 230_4, and a plurality of loads 240_1 to 240_4. Each of the loads 240_1 to 240_4 may be, but is not limited to, a D-flip-flop (DFF).

Each of the components 210, 220, 222_1, 222_2, 224_1 to 224_4, 230_1 to 230_4, and 240_1 to 240_4 corresponds to an electronic or digital circuit configured to operate in response to a clock signal.

Referring to FIGs. 1 and 3, the clock source 210 may be implemented as a clock signal generator or an oscillator operable to generate the clock signal CLK.

Among the clock tree cells 220, 222_1, 222_2, and 224_1 to 224_4, the clock tree cell 220 coupled to the clock source 210 may be implemented as the radiation-hardened circuit 100 illustrated in FIG. 1.

The first terminal IT of the radiation-hardened circuit 100 is coupled to a clock input terminal of each of the clock tree cells 222_1 and 222_2.

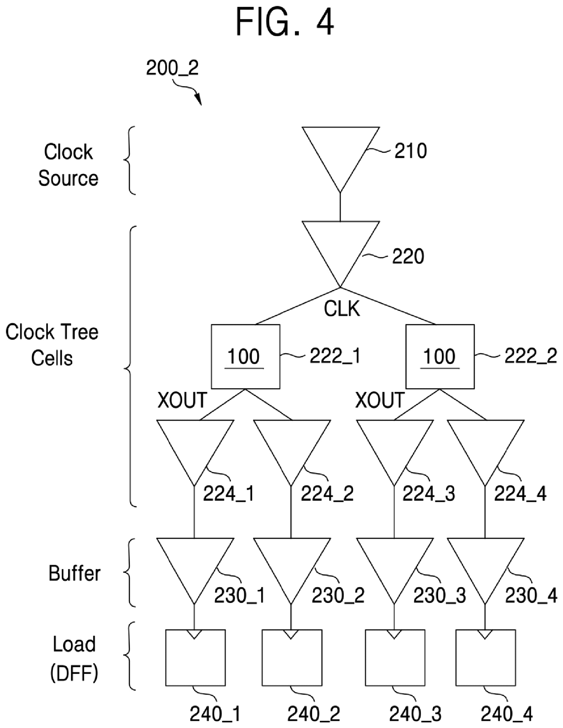

FIG. 4 is a conceptual diagram illustrating another embodiment of a clock tree incorporating the radiation-hardened circuit illustrated in FIG. 1. Referring to FIG. 4, a clock tree 200_2 (which may be referred to as a semiconductor device) corresponding to a clock distribution network includes a clock source 210, a plurality of clock tree cells 220, 222_1, 222_2, and 224_1 to 224_4, a plurality of buffers 230_1 to 230_4, and a plurality of loads 240_1 to 240_4.

Among the clock tree cells 220, 222_1, 222_2, and 224_1 to 224_4, each of the clock tree cells 222_1 and 222_2 may be implemented as the radiation-hardened circuit 100 illustrated in FIG. 1.

Each of the clock tree cells 222_1 and 222_2 receives the clock signal CLK output from the clock tree cell 220. The first terminal IT of the clock tree cell 222_1 is coupled to a clock input terminal of each of the clock tree cells 224_1 and 224_2, and the first terminal IT of the clock tree cell 222_2 is coupled to a clock input terminal of each of the clock tree cells 224_3 and 224_4.

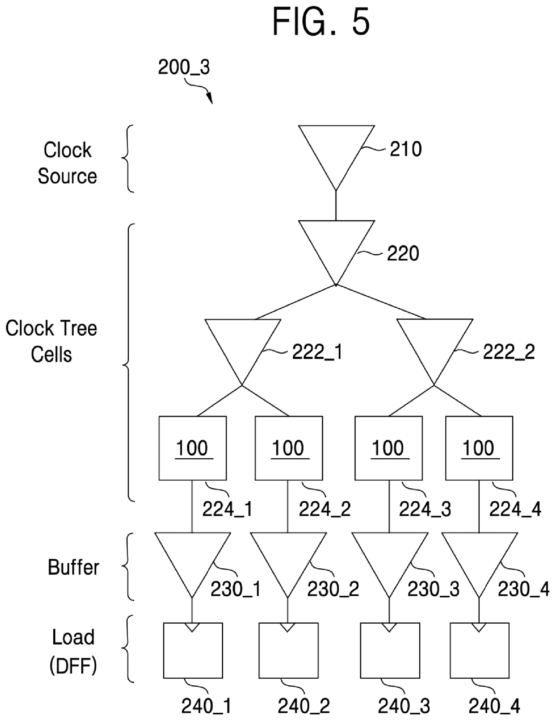

FIG. 5 is a conceptual diagram illustrating still another embodiment of a clock tree incorporating the radiation-hardened circuit illustrated in FIG. 1. Referring to FIG. 5, a clock tree 200_3 (which may be referred to as a semiconductor device) corresponding to a clock distribution network includes a clock source 210, a plurality of clock tree cells 220, 222_1, 222_2, and 224_1 to 224_4, a plurality of buffers 230_1 to 230_4, and a plurality of loads 240_1 to 240_4.

Among the clock tree cells 220, 222_1, 222_2, and 224_1 to 224_4, each of the clock tree cells 224_1 to 224_4 may be implemented as the radiation-hardened circuit 100 illustrated in FIG. 1.

Each of the clock tree cells 224_1 and 224_2 receives the clock signal CLK output from the clock tree cell 222_1, and each of the clock tree cells 224_3 and 224_4 receives the clock signal CLK output from the clock tree cell 222_2. The first terminal IT of each of the clock tree cells 224_1 to 224_4 is coupled to a clock input terminal of a corresponding one of the buffers 230_1 to 230_4.

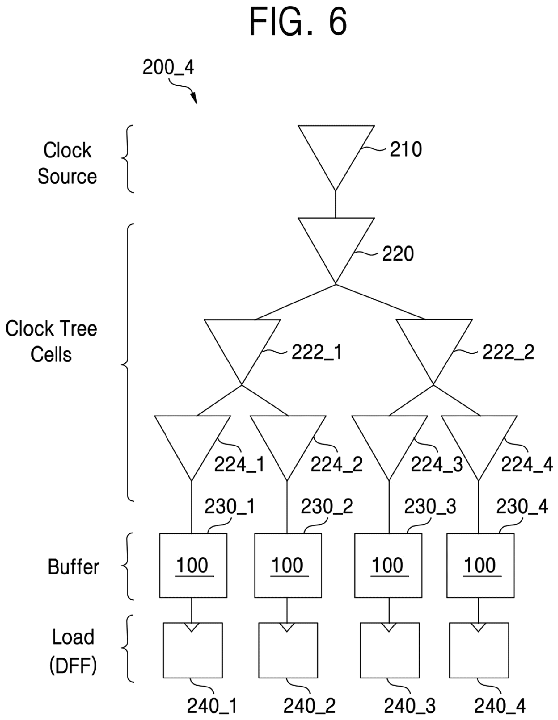

FIG. 6 is a conceptual diagram illustrating yet another embodiment of a clock tree incorporating the radiation-hardened circuit illustrated in FIG. 1. Referring to FIG. 6, a clock tree 200_4 (which may be referred to as a semiconductor device) corresponding to a clock distribution network includes a clock source 210, a plurality of clock tree cells 220, 222_1, 222_2, and 224_1 to 224_4, a plurality of buffers 230_1 to 230_4, and a plurality of loads 240_1 to 240_4.

Referring to FIGs. 3 and 6, each of the buffers 230_1 to 230_4 may be implemented as the radiation-hardened circuit 100 illustrated in FIG. 1.

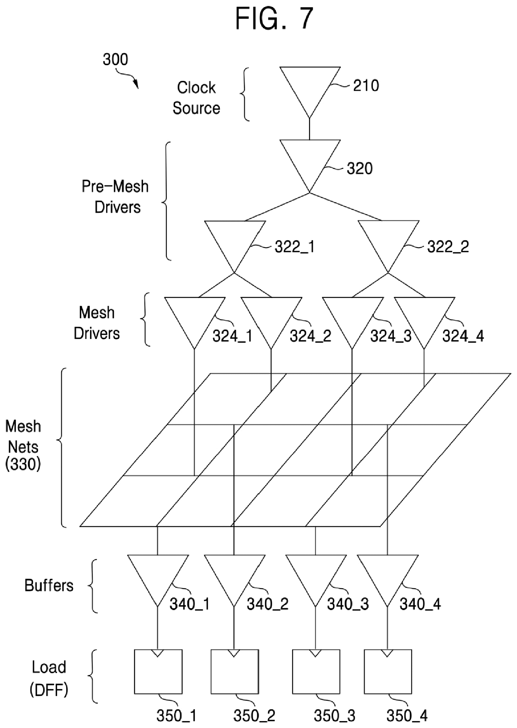

FIG. 7 is a conceptual diagram illustrating a clock mesh incorporating the radiation-hardened circuit illustrated in FIG. 1. Referring to FIG. 7, a clock mesh 300 (which may be referred to as a semiconductor device) corresponding to a clock distribution network includes a clock source 210, a plurality of pre-mesh drivers 320, 322_1, and 322_2, a plurality of mesh drivers 324_1 to 324_4, a plurality of mesh nets 330, a plurality of buffers 340_1 to 340_4, and a plurality of loads 350_1 to 350_4.

As described above with reference to FIGs. 3 to 6, it may be variously modified according to design specifications which of the components (e.g., 320, 322_1, 322_2, 324_1 to 324_4, and 340_1 to 340_4) is to be replaced with or implemented as the radiation-hardened circuit 100 illustrated in FIG. 1.

A semiconductor device including the clock distribution network (e.g., 200_1, 200_2, 200_3, 200_4, or 300) may be implemented as an integrated circuit (IC), a semiconductor chip, a central processing unit (CPU), a graphics processing unit (GPU), a processor, an application-specific integrated circuit (ASIC), a field-programmable gate array (FPGA), a system on chip (SoC), a memory device, a memory system including the memory device, or a communication system (e.g., a communication system such as Ethernet or Wi-Fi).

As described above with reference to FIGs. 3 to 7, within the clock distribution network (e.g., 200_1, 200_2, 200_3, 200_4, or 300), from the perspective of the radiation-hardened circuit 100, any component configured to supply a clock signal thereto functions as a clock signal generator.

While the present invention has been described with reference to the embodiments illustrated in the drawings, these embodiments are merely exemplary. It will be understood by those of ordinary skill in the art that various modifications and equivalent embodiments may be made therefrom without departing from the scope of the present invention. Therefore, the true technical scope of the present invention shall be defined by the technical spirit of the appended claims.

### INDUSTRIAL APPLICABILITY

The present invention is applicable to various types of electronic circuits or semiconductor devices.

## Claims

1. A radiation-hardened circuit comprising:
a time delay circuit configured to invert an input signal received through a first terminal and to output an inverted input signal through a second terminal;
a first output circuit configured to output a first clock signal by mitigating a transient voltage increase of a clock signal;
a second output circuit configured to output a second clock signal by mitigating a transient voltage decrease of the clock signal; and
a switch circuit configured to selectively transmit one of the first clock signal and the second clock signal to the first terminal in response to the inverted input signal.

2. The radiation-hardened circuit of claim 1, wherein:
the first output circuit is configured to output the first clock signal maintaining a low level by mitigating the transient voltage increase occurring at the low level of the clock signal; and
the second output circuit is configured to output the second clock signal maintaining a high level by mitigating the transient voltage decrease occurring at the high level of the clock signal.

3. The radiation-hardened circuit of claim 2, wherein at least one of the transient voltage increase and the transient voltage decrease is induced by at least one of radiation or noise.

4. The radiation-hardened circuit of claim 1, wherein the switch circuit comprises:
a first switch configured to control transmission of the first clock signal to the first terminal in response to the inverted input signal; and
a second switch configured to control transmission of the second clock signal to the first terminal in response to the inverted input signal.

5. The radiation-hardened circuit of claim 4, wherein the first switch and the second switch are configured to operate complementarily to each other.

6. The radiation-hardened circuit of claim 4, wherein one of the first switch and the second switch is a PMOS transistor, and the other of the first switch and the second switch is an NMOS transistor.

7. The radiation-hardened circuit of claim 1, wherein each of the first clock signal, the second clock signal, and the input signal has the same phase.

8. A semiconductor device comprising:
a clock signal generator configured to output a clock signal; and
a radiation-hardened circuit coupled to the clock signal generator,
wherein the radiation-hardened circuit comprises:
a time delay circuit configured to invert an input signal received through a first terminal and to output an inverted input signal through a second terminal;
a first output circuit configured to output a first clock signal by mitigating a transient voltage increase of the clock signal;
a second output circuit configured to output a second clock signal by mitigating a transient voltage decrease of the clock signal; and
a switch circuit configured to transmit one of the first clock signal and the second clock signal to the first terminal in response to the inverted input signal.

9. The semiconductor device of claim 8, further comprising a digital circuit comprising an input terminal coupled to the first terminal,
wherein the digital circuit is configured to use, as an operating clock signal, the one of the first clock signal and the second clock signal received through the input terminal.

10. The semiconductor device of claim 8, wherein:
the first output circuit is configured to output the first clock signal maintaining a low level by mitigating the transient voltage increase occurring at the low level of the clock signal; and
the second output circuit is configured to output the second clock signal maintaining a high level by mitigating the transient voltage decrease occurring at the high level of the clock signal.

11. The semiconductor device of claim 10, wherein:
at least one of the transient voltage increase and the transient voltage decrease is induced by at least one of radiation or noise; and
the switch circuit comprises:
a first switch configured to control transmission of the first clock signal to the first terminal in response to the inverted input signal; and
a second switch configured to control transmission of the second clock signal to the first terminal in response to the inverted input signal.

12. The semiconductor device of claim 11, wherein the first switch and the second switch are configured to operate complementarily to each other.

13. The semiconductor device of claim 8, wherein the semiconductor device is implemented as a clock distribution network.

14. The semiconductor device of claim 8, wherein the semiconductor device is a central processing unit (CPU), a graphics processing unit (GPU), an application-specific integrated circuit (ASIC), a field-programmable gate array (FPGA), a system on chip (SoC), a memory device, or a communication device.
